# EUROPEAN PATENT APPLICATION

(11) **EP 4 411 403 A1**
(43) Date of publication of application: **07.08.2024**
(21) Application number: 23154974.2
(22) Date of filing: 03.02.2023
(51) Int. Cl.: G01R 31/69

(54) **A METHOD FOR EXECUTING A TEST OF A QUALITY OF A CONNECTION BETWEEN A CONNECTOR OF A MOTOR VEHICLE AND A CONTACT ELEMENT OF THE MOTOR VEHICLE, COMPUTER PROGRAM PRODUCT, COMPUTER-READABLE STORAGE MEDIUM AS WELL AS A QUALITY TESTING DEVICE**

(71) Applicant: VOLKSWAGEN AG, 38440 Wolfsburg (DE); Aptiv Technologies AG, 8200 Schaffhausen (CH)
(72) Inventor: PORTE, Maxime, 90471 Nürnberg (DE); KOLMER, Philipp, 38108 Braunschweig (DE); ECKHARDT, Ingo, 38542 Leiferde (DE)
(74) Representative: Hofstetter, Schurack & Partner

(57) **Abstract**

The invention relates to a method for executing a test of a quality of a connection (2) between a connector (3) of a motor vehicle and a contact element (4) of the motor vehicle by a quality testing device (1), comprising the steps of providing a first force (F_{K}) of the connection (2) of the connector (3) and the contact element (4); executing a second force (F_{M}) on the connector (3) by a motion mechanism (14) of the quality testing device (1), wherein the second force (F_{M}) is perpendicular to the first force (F_{K}), and wherein the second force (F_{M}) is executed basically in a connection direction of the connector (3) and the contact element (4); capturing at least an electrical contact resistance (R) of the connection (2) by a first capturing device (5) of the quality testing device (1) and capturing a motion distance (S_{c}) of the connector (3) relative to the contact element (4) by a second capturing device (6) of the quality testing device (1); and analyzing the quality of the connection (2) depending on the captured electrical contact resistance (R) and the captured motion distance (S_{c}) by an electronic computing device (7) of the quality testing device (1). Furthermore, the invention relates to a computer program product and to quality testing device (1).

## Description

The invention relates to a method for executing a test of a quality of a connection between a connector of a motor vehicle and a contact element of the motor vehicle by a quality testing device according to the independent claim 1. Furthermore, the invention relates to a computer program product, a computer-readable storage medium as well as to a quality testing device.

The development of driver assistance systems and autonomous driving vehicles in the automotive industry should enable new mobility concepts to be experiences in the future and, above all, guarantee accident-free mobility. Reliable components in the motor vehicle are essential for the realization of this project. This includes the vehicle electrical system, which is responsible for communication as well as energy and signal distribution with its various components. The connection of different components, for executing control units, wiring harnesses, actuators, sensors, is ensured by electric connectors. The vehicle electrical system, and thus also the electrical contacts, are influenced in the motor vehicle by a wide variety of influences for operation and the environment. This includes, for example, vibrations from the drive train or from road excitation, operating in ambient temperatures, a cycle temperature changes, electrical loads in operation and voltage changes, humidity and corrosion, and polluted gases and atmospheric pollution.

Vibration and temperature change loads, in particular lead to the mechanism of fretting corrosion in electrical connectors. This mechanism is characterized by the fact that a relative movement occurs between the contact blade, in particular the contact element, and the contact socket, in particular the connector. This relative movement leads to wear outs and equally to oxidation of the contact zone of the electric connector. A cycle repetition of this process can lead to an agglomeration of oxidic products in the contact zone, so that the electrical contact resistance of this connection increases. This can lead to a failure of a component. Appropriate measures to avoid this degradation mechanism are listed.

In can be deduced from this that an important field of action is to be able to determine the variability and failure probability of various components. So far, statements on failure probabilities are preliminarily possible in the basis of empirical values from practical application. The use of, for example, electrical plug contacts for corresponding applications is estimated for the requirements derived from experience.

At present, statements about the probability of failure of electrical plug contacts are made exclusively on the basis of empirical values.

Furthermore, various models are discussed in science, which enable the determination of a failure probability or FIT rate (failure-in-time rate). The FIT rate is an important parameter for reliable considerations. The methods mentioned in the science are based on experimental tests and supplemented by mathematical models. For example, multi variable service life tests are carried out, which consists of alternating vibration and temperature change load. The mechanism of fretting corrosion, but also the other degradation mechanism, are triggered. By determining the corresponding FIT rates in the test, possible FIT rates in real operation can be extrapolated by mathematical models. However, this implies the assumption of corresponding loads in real operation.

The determination of the probability of failure via applicable values is not based on any scientific and reproduceable tests. Therefore, the susceptibility to misjudgment or misinterpretation is extremely high. Furthermore, the supplementary model combinations from the literature, consisting of experimental tests and mathematical models, are characterized by a high expenditure of time and money. A large number of test parts is required to collect valid and statistically reliable data. Similarly, the effort continues to increase because each contact system must be tested and evaluated separately.

Furthermore, it is known that the tests are accelerated by increased loads, for example, excessing temperature and vibration. However, this bears the risk that other degradation mechanism are triggered than the mechanism that are primary intended to be provoked. This could lead to misinterpretations in the tests as well as in the calculations of the FIT rate.

It is an object of the invention to provide a method, a computer program product, a computer-readable storage medium as well as a quality testing device, by which an efficient way for testing a quality of a connector of a motor vehicle and a contact element of the motor vehicle is provided.

This object is solved by a method, a computer program product, a computer-readable storage mesium as well as a quality testing device according to the independent claims. Advantageous embodiments are presented in the dependent claims.

One aspect of the invention relates to a method for executing a test of a quality of a connection between a connector of a motor vehicle and a contact element of the motor vehicle by a quality testing device. A first force of the connection of the connector and the contact element is provided. A second force on the connector is executed by a motion mechanism of the quality testing device, wherein the second force is perpendicular to the first force, and wherein the second force is executed basically in a connection direction of the connector and the contact element. At least an electrical contact resistance of the connection is captured by a first capturing device of the quality testing device and a motion distance of the connector relative to the contact element is captured by a second capturing device of the quality testing device. The quality of the connection is analyzed depending on the captured electrical contact resistance and the captured motion distance by an electronic computing device of the quality testing device.

In particular, empirical proof of the failure probability of so-called electrical plug-in contacts, in particular the connection of the connector and the contact element, is provided, wherein a quality test is proposed in which a part of the contact pair is loaded with, for example, the second force higher than the first force to provoke surface wear or resistance increase.

As a result, it is possible to evaluate the resistance stability as a function of forces that can be impressed by connecting cables during driving, in particular as inertial forces.

In addition to the effect of dynamic loads, the influence of other typical vehicle loads, such as heat and corrosion can also be taken into account. Corresponding loads on the test samples can take place at the time or before the proposed test. This creates the possibility to empirically evaluate failure probabilities of contact elements. Therefore, an efficient way for testing the quality, in particular in a time saving and cost saving manner, is provided.

According to an embodiment, the second force is executed as a higher force than the first force. F_{K} is given by the design, wherein F_{K} is the first force. The surface-dependent friction counteracts these forces, wherein the surface-dependent friction is the second force F_{M}. With a second force higher than the first force, a motion of the connector relatively to the contact element is provided, and depending on this motion, the test may be performed.

In another embodiment, the second force is generated by a spring element of the quality testing device. In particular, a spring constant of the spring element is taken into consideration during the analyzing. Furthermore, a spring deflection of the spring element is taken into consideration during the analyzing and/or the spring deflection is adapted during the execution of the test. In particular, according to this embodiment, the spring element may be a compression spring which may be cyclically tensioned against the test sample connection. The force acting on the test sample connection is determined by the effective spring travel, which may be regarded as the spring deflection, and the spring rate C_{F}, which may be regarded as the spring constant. The second force can be changed and adjusted flexibly and precisely within certain limits by changing the effective spring travel S_{M}.

According to another embodiment, the second force is generated by a rotating element of the quality testing device. In particular, the rotating element is connected with the spring element. With the rotating element an easy way for generating cyclically the second force is provided, and therefore an easy way for testing the connection is provided. In particular, a frequency of the test and/or an amount of test is adjusted by the rotating element.

According to another embodiment, the second force is cyclically executed on the connection. Therefore, the tests may be executed cyclically, and therefore a high usage of the connection may be simulated. Therefore, the connection can be tested in an efficient way.

In another embodiment, a predetermined amount of test cycles is executed for testing the quality. For example, a cyclic time may be 1 Hz, and the test may be four hours. Therefore, a predetermined amount of test cycles is given, and therefore the analyzing of the quality may be realized in an objective way.

In particular, the method may be implemented in the electronic computing device. Therefore, the electronic computing device may comprise a computer program product comprising program code means for performing at least a part of the method. The computer program product may also be regarded as a computer program. Furthermore, the invention may also relate to a computer-readable storage medium comprising at least the computer program product according to the preceding aspect.

Another aspect of the invention relates to a quality testing device for executing a test of a quality of a connection between a connector of a motor vehicle and a contact element of the motor vehicle, comprising at least a motion mechanism, a first capturing device, a second capturing device, and an electronic computing device, wherein the quality testing device is configured for performing a method according to any of the preceding aspect. In particular, the method is performed by the quality testing device.

The electronic computing device may comprise electronic means, for example processors, circuits, in particular integrated circuits, and further electronic means, for performing a method.

Advantageous forms of embodiments of the method are to be regarded as advantageous forms of embodiments of the quality testing device. Therefore, the quality testing device may comprise means for performing the method.

For use cases, new situations which may arise in the method and which are not explicitly described here, it may be provided that, in accordance with the method, an error message and/or a prompt for user feedback is output and/or a default setting and/or a predetermined initial state is set.

The invention also includes further embodiments of the method of the quality testing device according to the invention which have features as already described in connection with the further embodiments of the method according to the invention. For this reason, the corresponding further embodiments of the quality testing device according to the invention are not described again here.

The invention also includes combinations of the features of the embodiments described.

Examples of the embodiments of the invention are described below. For this purpose, the figures show:
- Fig. 1: a schematic block diagram according to an embodiment of quality testing device; and
- Fig. 2: a schematic diagram according to a test of the quality testing device.

The embodiments explained below are preferred embodiments of the invention. In the examples of embodiment, the components described each represent individual features of the invention which are to be considered independently of one another and which also further form the invention independently of one another in each case and are thus also to be regarded as components of the invention individually or in combination other than the shown.

Furthermore, the described embodiments can also be supplemented by further of the already described features of the invention.

In the figures, functional identical elements are each given the same reference signs.

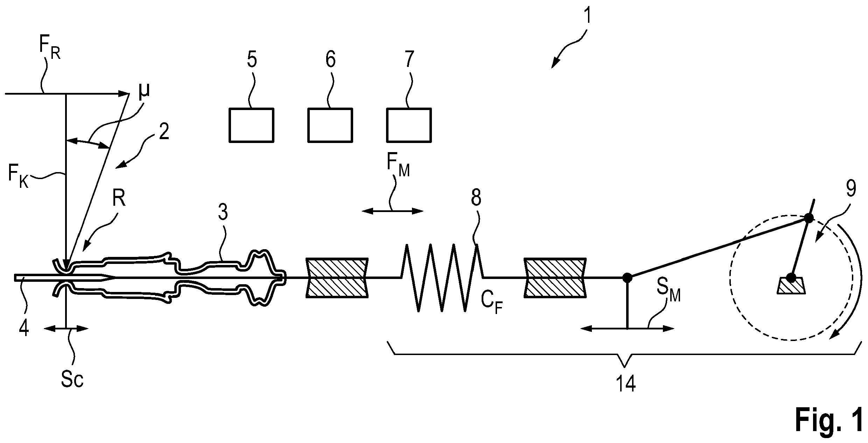

Fig. 1 shows a schematic block diagram according to an embodiment of the quality testing device 1 for executing a test of a quality of a connection 2 between a connector 3 of a not shown motor vehicle and a contact element 4 of the motor vehicle. The quality testing device 1 comprises at least a motion mechanism 14, a first capturing device 5, a second capturing device 6 as well as an electronic computing device 7.

According to an embodiment of the method, a first force F_{K} of the connection 2 of the connector 3 and the contact element 4 is provided. A second force F_{M} on the connector 3 is executed by the motion mechanism 4, wherein the second force F_{M} is perpendicular to the first force F_{K}, and wherein the second force F_{M} is executed basically in a connection direction of the connector 3 and the contact element 4. At least an electrical contact resistance R of the connection 2 is captured by the first capturing device 5 and a motion distance Sc of the connector 3 relative to the contact element 4 is captured by the second capturing device 6. The quality of the connection 2 is analyzed depending on the captured electrical contact resistance R and the captured motion distance Sc by the electronic computing device 7.

In particular, the second force F_{M} is executed as a higher force than the first force F_{K}. Furthermore, the second force F_{M} is generated by a spring element 8 of the quality testing device 1. A spring constant C_{F} of the spring element 8 is taken into consideration during the analyzing. Furthermore, a spring deflection S_{M} of the spring element 8 is taken into consideration during the analyzing and/or the spring deflection S_{M} is adapted during the execution of the test. Furthermore, Fig. 1 shows that the second force F_{M} is generated by a rotating element 9 of the quality testing device 1. In particular, the second force F_{M} is cyclically executed to the connection 2. Furthermore, a predetermined amount n of test cycles is executed for testing the quality. Furthermore, a frequency f for the rotating element 9 and therefore for the cyclically executed second force F_{M} may be provided.

In particular, Fig. 1 shows, as an empirical prove of the failure probability of the electrical plug-in contacts, in other words the connection 2, the qualification test is proposed in which a part of the contact pairs is loaded with the second force F_{M} greater than the first force F_{K} to provoke surface wear or resistance increase. The connector 3 is loaded with the second force F_{M} higher than the first force F_{K} in the mating direction. At the same time, the electrical contact resistance R and the motion distance Sc are measured continuously over the duration of the test.

The proposed test can be implemented constructively as shown in Fig. 1. In this exemplary design, a compression spring element 8 is cyclically tensioned against the test sample connector 3. The force acting on the test sample connector 3 is determined by the effective spring travel/deflection S_{M} and the spring rate/constant C_{F}. The second force F_{M} can be changed and adjusted flexibly and precisely within certain limits by changing the spring deflection S_{M}.

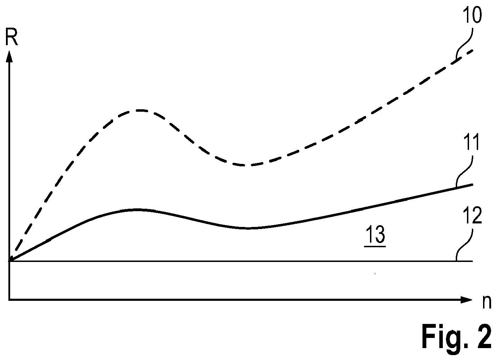

Fig. 2 shows a schematic diagram according to an analyzation of the connection 2. In particular, on the x-axis the amount of tests n is applied, and on the y-axis the electrical contact resistance R is applied.

Fig. 2 shows a first graph 10, a second graph 11, a third graph 12 as well as an area 13 between the second graph 11 and the third graph 12.

In particular, the area 13 describes an area where a friction force F_{R} is depending on an angle µ between the friction force F_{R} and the first force F_{K}.

According to the shown embodiment, the first graph 10 describes that the friction force F_{R} is very low compared to the second force F_{M}. In particular, this means that the static friction is clearly overcome and is no longer effective. Therefore, a significant relative movement of the contact surfaces arises. Therefore, a significant increase of the electrical contact resistance R is expected due to fretting corrosion.

The second graph 11 shows that the friction force F_{R} is lower than the second force F_{M}. Therefore, the motion distance Sc occurs. This means that the static friction is overcome, but still has an effect. Relative movements of the contact surfaces are expected. The electrical contact resistance R increases due to fretting corrosion and can be safely expected.

In the area 13 the static friction is not reliably overcome. Relative movement of the contact surfaces is uncertain and a arise of the electrical contact resistance R due to fretting corrosion is possible.

The third graph 12 describes that the static friction is not overcome. No relative movement of the contact surfaces is detected. Therefore, no rise of the electrical contact resistance R is expected due to fretting corrosion.

In particular, the Fig. 2 shows the resistance changes due to fretting corrosion depending on the second force F_{M} relative to the friction force F_{R}. For the second force F_{M} equals the friction force F_{R} onwards, movement of the connector 3 relative to the contact element 4 will take place, causing resistance changes, wherein the electrical contact resistance R is depending on the second force F_{M} divided by the friction force F_{R} due to fretting corrosion.

The Fig. 2 shows an assumed curve of the electrical contact resistance R over time based on the number of cycles n as a function of the ratio F_{K} divided by F_{M}.

### Reference signs

- 1: quality testing device
- 2: connection
- 3: connector
- 4: contact element
- 5: first capturing device
- 6: second capturing device
- 7: electronic computing device
- 8: spring element
- 9: rotating element
- 10: first graph
- 11: second graph
- 12: third graph
- 13: area
- 14: motion mechanism
- n: amount of cycles
- f: frequency
- R: electrical contact resistance
- F_{K}: first force
- F_{M}: second force
- F_{R}: friction force
- µ: angle
- Sc: motion distance
- S_{M}: spring deflection
- C_{F}: spring constant

## Claims

1. A method for executing a test of a quality of a connection (2) between a connector (3) of a motor vehicle and a contact element (4) of the motor vehicle by a quality testing device (1), comprising the steps of:
- Providing a first force (F_{K}) of the connection (2) of the connector (3) and the contact element (4);
- Executing a second force (F_{M}) on the connector (3) by a motion mechanism (14) of the quality testing device (1), wherein the second force (F_{M}) is perpendicular to the first force (F_{K}), and wherein the second force (F_{M}) is executed basically in a connection direction of the connector (3) and the contact element (4);
- Capturing at least an electrical contact resistance (R) of the connection (2) by a first capturing device (5) of the quality testing device (1) and capturing a motion distance (S_{c}) of the connector (3) relative to the contact element (4) by a second capturing device (6) of the quality testing device (1); and
- Analyzing the quality of the connection (2) depending on the captured electrical contact resistance (R) and the captured motion distance (S_{c}) by an electronic computing device (7) of the quality testing device (1).

2. The method according to claim 1,
**characterized in that**,
the second force (F_{M}) is executed as a higher force than the first force (F_{K}).

3. The method according to claim 1 or 2,
**characterized in that**,
the second force (F_{M}) is generated by a spring element (8) of the quality testing device (1).

4. The method according to claim 3,
**characterized in that**,
a spring constant (C_{F}) of the spring element (8) is taken into consideration during the analyzing.

5. The method according to claim 3 or 4,
**characterized in that**,
a spring deflection (S_{M}) of the spring element (8) is taken into consideration during the analyzing.

6. The method according to any of claims 3 to 5,
**characterized in that**,
a spring deflection (S_{M}) is adapted during the execution of the test.

7. The method according to any of claims 3 to 6,
**characterized in that**,
the spring element (8) is provided as a compression spring.

8. The method according to any of claims 1 to 7,
**characterized in that**,
the second force (F_{M}) is generated by a rotating element (9) of the quality testing device (1).

9. The method according to any of claims 1 to 8,
**characterized in that**,
a frequency of the test and/or an amount of tests is adjusted by the rotating element.

10. The method according to any of claims 1 to 9,
**characterized in that**,
the second force (F_{M}) is cyclically executed on the connection (2).

11. The method according to any of claims 1 to 10,
**characterized in that**,
a predetermined amount (n) of test cycles is executed for testing the quality.

12. A computer program product comprising program code means for performing a method according to any of claims 1 to 11.

13. A computer-readable storage medium comprising at least the computer program product according to claim 12.

14. A quality testing device (1) for executing a test of a quality of a connection (2) between a connector (3) of a motor vehicle and a contact element (4) of the motor vehicle, comprising at least a motion mechanism (14), a first capturing device (5), a second capturing device (6), and an electronic computing device (7), wherein the quality testing device (1) is configured for performing a method according to any of claims 1 to 11.
